# EUROPEAN PATENT SPECIFICATION

(11) **EP 4 376 299 B1**
(45) Date of publication and mention of the grant of the patent: **06.05.2026**
(21) Application number: 22209698.4
(22) Date of filing: 25.11.2022
(51) Int. Cl.: H03K 17/0412, H03K 17/16, H03K 17/687, H03K 19/0185, H03K 19/017

(54) **A CONTROL CIRCUIT FOR AN OUTPUT DRIVER WITH A SLEW RATE CONTROL CIRCUIT AND AN OUTPUT DRIVER COMPRISING THE SAME**
STEUERSCHALTUNG FÜR EINEN AUSGANGSTREIBER MIT EINER ANSTIEGSGESCHWINDIGKEITSSTEUERSCHALTUNG UND AUSGANGSTREIBER DAMIT
CIRCUIT DE COMMANDE POUR UN CIRCUIT D'ATTAQUE DE SORTIE AVEC UN CIRCUIT DE COMMANDE DE VITESSE DE BALAYAGE ET CIRCUIT D'ATTAQUE DE SORTIE LE COMPRENANT

(43) Date of publication of application: 29.05.2024
(73) Proprietor: Nexperia B.V., 6534 AB Nijmegen (NL)
(72) Inventor: Asam, Geethanadh, 6534AB Nijmegen (NL); Pandya, Keyur, 6534AB Nijmegen (NL)
(74) Representative: Pjanovic, Ilija

(56) References cited:
- US-A1- 2006 119 326
- US-A1- 2010 176 783
- US-A1- 2021 336 611
- US-B1- 10 790 818

## Description

### Technical Field

The present disclosure generally relates to an output driver, more particularly, to a control circuit for an output driver with a slew rate control circuit as outlined in the preamble of claim 1.

### Background

An output driver is a circuit for driving an output pad to which a predetermined load is connected in order to output a data from a semiconductor device. A push-pull type driver is known as a widely used output driver, and a slew rate control circuit is generally used in connection with the driver for controlling an output slew rate of the driver.

The slew rate shows how fast voltage level of an output signal changes. The slew rate is defined as a slope showing a ratio between a voltage level change and a unit time.

Applications like Inter-Integrated Circuit, I²C, Electromagnetic Interference, EMI, effected circuits require slow transition output signals to minimize EMI to meet the standard requirements for rise/fall times. For such applications it is necessary to limit rise and fall times of the output in a controlled manner.

A conventionally known typical slew rate control circuit controls the output slew rate by injecting a well-defined current into the driver. This current is always a well-controlled current and involves large turn on time.

US 2010/176783A1 discloses a switching device drive circuit for receiving a pulse signal, and outputting a drive signal to a control terminal of a switching device including a power converting circuit for a predetermined period corresponding to the pulse signal, and a control circuit for changing a voltage supplied or a current flowing, as a drive signal, to or through the control terminal of the switching device, to a voltage or a current different from a predetermined voltage or a predetermined current; and a control voltage detecting circuit for detecting a voltage of the control terminal of the switching device.

US 10790818 B1 discloses a A gate driver circuit includes a first power supply rail providing a first fixed supply voltage; a second power supply rail providing a second fixed supply voltage; a transistor including a gate terminal having a gate voltage; and a gate driver integrated circuit (IC) supplied with the first fixed supply voltage and the second fixed supply voltage, the gate driver IC including an output terminal configured to provide a gate drive voltage at the output terminal in order to drive the transistor between switching states.

US 2006/119326 A1 discloses a switching voltage regulator includes a switching transistor connected to conduct a current between a supply voltage and a first node in response to a control signal which cycles the transistor on and off, and a pre-driver circuit which provides the control signal.

US 2021/336611 A1 discloses slew-rate controlled drivers.

For slew rate control circuit applications requiring small latency while meeting slew rate requirements, it is desired that the turn on time may be shortened.

In consideration of the above, it is desirable that the turn on time of an output driver with a slew rate control circuit may be improved, without impacting the slew rate.

### Summary

In a first aspect of the present disclosure, there is presented a control circuit for an output driver with a slew rate control circuit as defined in the characterizing part of claim 1. The control circuit comprises:
- a turn-on facilitating module having a control input and configured to be connected to the output driver and to supply a supplementary voltage to the output driver in response to a control voltage at the control input; and
- a sensing module configured to be connected to the turn-on facilitating module and the output driver and to switch off the turn-on facilitating module in response to an input voltage of the output driver sensed by the sensing module.

The present disclosure is based on the insight that the turn-on time of an output driver can be reduced or shortened by supplying a supplementary voltage to the output driver by way of a turn-on facilitating module. The supplementary voltage is supplied in addition to a current injected by a slew rate control circuit for turning on the output driver.

The supplementary voltage in combination with the current injected by the slew rate control circuit ensures the turning on of the output driver in a short amount of time. The time required to turn on the output driver by for example charging a gate of a transistor functioning as the output driver is not dependent on a bias current used during the subsequent slew rate period.

The turn-on facilitating module operates only during a turn-on period of the output driver. Therefore, a sensing module is configured to switch off the turn-on facilitating module by sensing an input voltage of the output driver. Once the input voltage reaches a threshold value, the turn-on facilitating module is switched off, ensuring that the slew rate period remains unimpacted.

According to the invention, the turn-on facilitating module comprises a turn-on path configured to be connected to an input terminal of the output driver and to connect a supply voltage to the input terminal of the output driver in response to the control voltage.

Such a turn-on path is configured to supply the supplementary voltage to the input terminal of the output driver. The supplementary voltage is provided by connecting the supply voltage of a system comprising the output driver to the input terminal of the output driver when the control voltage is applied to the control input of the turn-on facilitating module.

According to the invention, the turn-on path comprises a first switch and a second switch connected in series, an enable terminal of the first switch coupled to the control voltage, an enable terminal of the second switch coupled to the supply voltage and an output terminal of the sensing module, an output terminal of the second switch configured to be connected to the input terminal of the output driver.

Such a turn-on path is connected to the input terminal of the output driver. It allows the supply voltage to be supplied as the supplementary voltage to the input terminal of the output driver when the control voltage is applied at the control input. Moreover, the turn-on path is disconnected under an output from the sensing module, when a voltage at the input terminal of the output driver is sufficiently high.

According to the invention, the first switch comprises a first PMOS transistor and the second switch comprises a second PMOS transistor, a source of the first PMOS transistor coupled to the supply voltage and a drain of the first PMOS transistor is coupled to a source of the second PMOS transistor, a drain of the second switch is configured to be connected to the input terminal of the output driver.

The first and second PMOS transistors are connected in series. As described the above, the enable terminal, that is, the gate, of the first PMOS transistor is coupled to the control voltage. The first PMOS transistor therefore is enabled upon the application of the control voltage, thereby also enabling the second PMOS transistor. The supply voltage therefore is supplied to the input terminal of the output driver via the output terminal, or the drain of the second PMOS transistor.

In an example of the present disclosure, a gate of the first PMOS transistor is coupled to the control voltage via a first inverter, a gate of the second PMOS transistor is coupled to the supply voltage via a second inverter and a feedback resistor connected in series.

This allows the first PMOS transistor to be enabled with a logic high voltage. At the same time when the first PMOS transistor turns on, the second PMOS transistor is enabled by the supply voltage.

In an example of the present disclosure, the sensing module comprises a third switch configured to have its input terminal connected to the input terminal of the output driver and an output terminal coupled to the supply voltage and the enable terminal of the second switch.

The input terminal of the third switch is configured to sense the input voltage of the output driver. The third switch therefore operates under the control of the input voltage of the output driver, thereby switching off the turn-on path of the turn-on facilitating module by switching off the second switch of the turn-on path.

In an example of the present disclosure, the third switch comprises a first NMOS transistor, a source of the first NMOS transistor is connected to the control voltage via a second NMOS transistor.

In an example of the present disclosure, a source of the second NMOS transistor is coupled to GND and a gate of the second NMOS transistor is coupled to the control voltage.

This ensures that the turn-on path is disabled when the control voltage is at a logic low level.

In an example of the present disclosure, the output terminal of the first NMOS transistor is coupled to a node between the second inverter and the feedback resistor.

It therefore ensures that the second PMOS transistor of the turn-on path is not affected by the sensing module until the input voltage of the output driver reaches the threshold value as to enable the first NMOS transistor.

According to the invention, the control circuit for the output driver further comprises a limiting resistor having a first terminal connectable to the input terminal of the output driver and a second terminal coupled to the turn-on facilitating module and the sensing module, thereby configuring the drain of the second switch to be connected to the input terminal of the output driver via the limiting resistor.

The limiting resistor is configured to prevent any spike in the output driver's gate voltage and to prevent the output from being quickly discharged before the turn-on facilitating module is disabled. The output of the output driver therefore has constant slew rate throughout the slewing period.

In an example of the present disclosure, the second terminal of the limiting resistor is coupled to the drain of the second PMOS switch and the input terminal of the third switch.

The limiting resistor is thereby connected between the output of the turn-on facilitating module as well as the input of the sensing module and the input terminal of the output driver.

In an example of the present disclosure, the limiting resistor has a resistance in a range of 200 Ohm to 600 Ohm.

A resistance in the defined range can effectively prevent spike in the output driver's gate voltage and helps to stabilise the output.

A second aspect of the present disclosure presents an output driver comprising a slew rate control circuit and the control circuit for the slew rate control circuit according to the first aspect of the present disclosure.

In an example of the present disclosure, the output driver comprises an open drain output driver.

In another example of the present disclosure, the output driver comprises a push pull driver.

The control circuit as described in the first aspect of the present disclosure may be advantageously used in both the open drain output driver and the push pull driver, allow both drivers to have low propagation delay with well controlled slew rate.

The above mentioned and other features and advantages of the disclosure will be best understood from the following description referring to the attached drawings. In the drawings, like reference numerals denote identical parts or parts performing an identical or comparable function or operation.

### Brief description of the drawings

Fig. 1 schematically illustrates a conventional open drain driver with a slew rate control circuit.
Fig. 2 schematically illustrates operation states of the driver of Fig. 1.
Fig. 3 is a block diagram schematically illustrating a control circuit for an output driver with a slew rate control circuit.
Fig. 4 schematically illustrates a proposed control circuit for an output driver with a slew rate control circuit.
Fig. 5 shows different node voltages of the control circuit of Fig. 4 during driver off state.
Fig. 6 shows different node voltages of the control circuit of Fig. 4 during fast turn on state.
Fig. 7 shows different node voltages of the control circuit of Fig. 4 during slew rate state.
Fig. 8 shows different node voltages of the control circuit of Fig. 4 during driver fully on state.
Fig. 9 schematically illustrates comparison between slew rate circuit without and with the proposed control circuit.
Fig. 10 schematically illustrates comparison between slew rate circuit without and with the limiting resistor.
Fig. 11 schematically using the fast turn on control circuit for a PMOS driver.

### Detailed description

Embodiments contemplated by the present disclosure will now be described in more detail with reference to the accompanying drawings. The disclosed subject matter should not be construed as limited to only the embodiments set forth herein. Rather, the illustrated embodiments are provided by way of example to convey the scope of the subject matter to those skilled in the art.

The present disclosure describes a control circuit for an output driver with a slew rate control circuit.

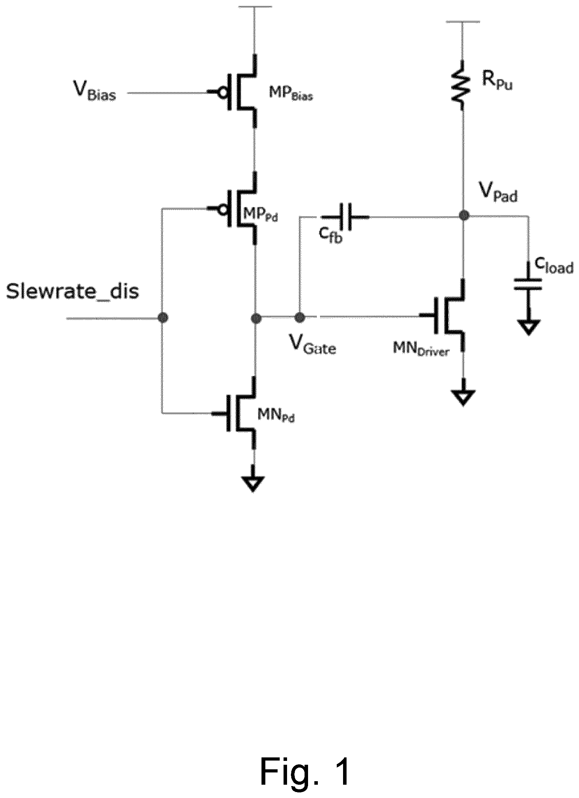

Figure 1 schematically illustrates a conventional open drain driver with a slew rate control circuit.

The slew rate control circuit for the open drain driver consists of three components, which are respectively: 1. an open drain driver comprising a transistor MN_{Driver} with a pull up resistor R_{Pu}; 2. A feedback capacitance C_{fb} and bias current injection transistor MP_{Bias} configured to obtain required slew rate on output V_{pad}; and 3. A disable circuit with transistors MN_{pd} and MP_{pd}.

The driver NMOS's slew rate is defined by the capacitance C_{fb} and injection current I_{bias} from the transistor MP_{Bias}. The driver circuit suffers from turn on time especially when the I_{bias} is very small to meet slew rate requirements.

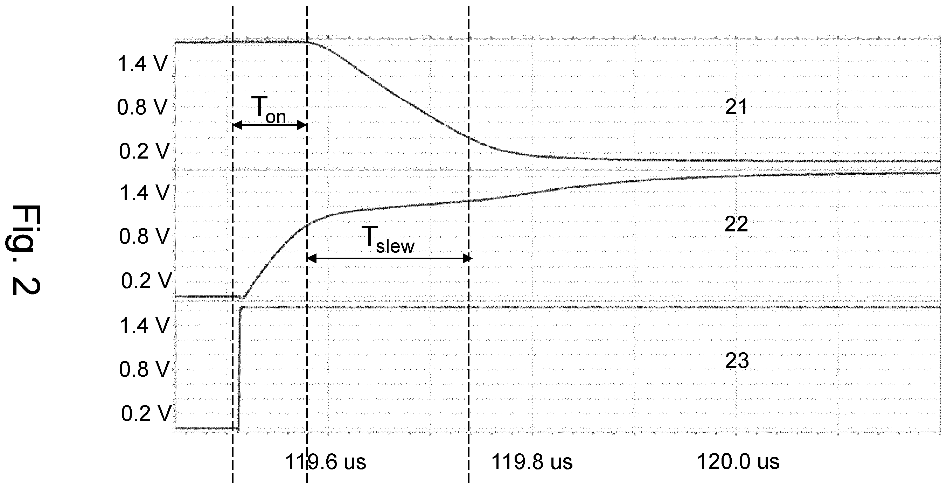

Figure 2 schematically illustrates operation states of the driver of Figure 1.

Graphs from top to bottom of Figure respectively represents a slew rate driver output 21, a driver's gate voltage 22 and a slew rate circuit enable signal 23 over time.

Tₒₙ indicates a time needed to turn on the driver NMOS, T_{slew} indicates a slewing period of the driver NMOS. It is seen and untill the gate voltage of the driver NMOS reaches Vₜ of the transistor the slew rate circuit is not turned on. The turn on time is pretty large for worse case Process, Voltage, and Temperature, PVT, corner.

A control circuit is proposed by the present disclosure to reduce the time needed to turn on an output driver as described above.

In the following description, the terms "control circuit" and "fast turn on circuit" and "fast turn on control circuit" are used interchangeably.

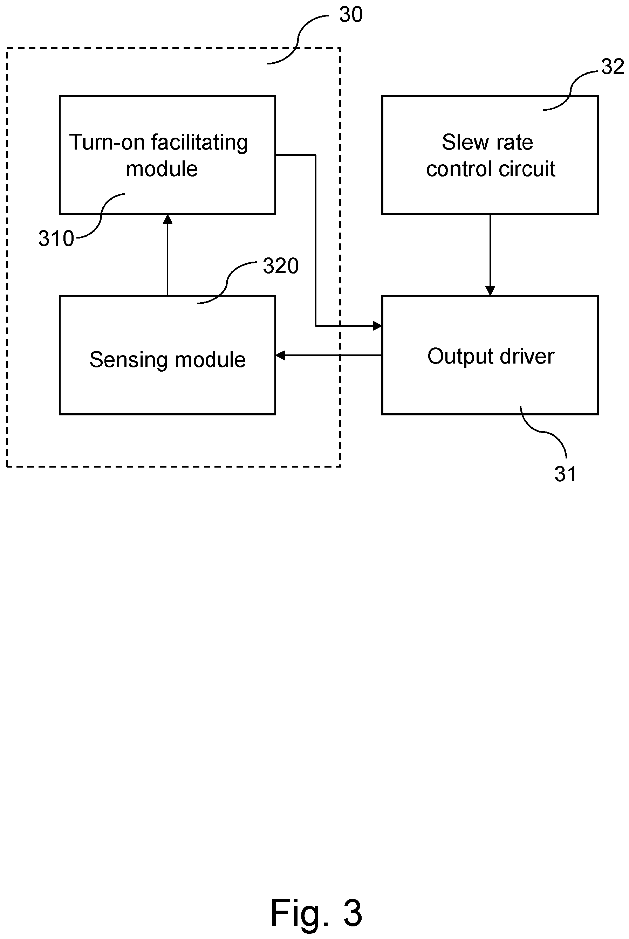

Figure 3 is a block diagram schematically illustrating a control circuit 301 for an output driver 31 with a slew rate control circuit 32.

The output driver 31 and the slew rate control circuit 32 for controlling a slew rate of the output driver 31 may be for example as described above with reference to Figure 1.

The key features of the control circuit 30 comprises a turn-on facilitating module 310 and a sensing module 320. The turn-on facilitating module 310 is also referred to as a fast turn on circuit, the sensing module 320 comprises a Vt detection circuit. There is also an enable and disable mechanism for the fast turn on circuit which is not shown in Figure 3.

The turn-on facilitating module 310 is configured to be connectable to the output driver 31, that is, to an input terminal of the output driver 31. The turn-on facilitating module 310 is configured to supply a supplementary voltage to the output driver 31, in addition to a regular turn-on current provided by the slew rate control circuit 32 of the output driver 31.

The sensing module 320 is configured to be connected to the turn-on facilitating module 310 and connectable to the output driver 31. The sensing module 320 is configured to sense an input voltage of the output driver 31 and use a feedback control mechanism to turns off the fast turn on circuit or the turn-on facilitating module 310.

Optionally, the control circuit 30 of the present disclosure further comprises a current limiter (not shown in Figure 3), which is configured to ensure correct operation for minimum load capacitance and fast process case. The current limiter will be described in detail in the following

The following provides detailed description of embodiments of the control circuit 30 contemplated by the present disclosure.

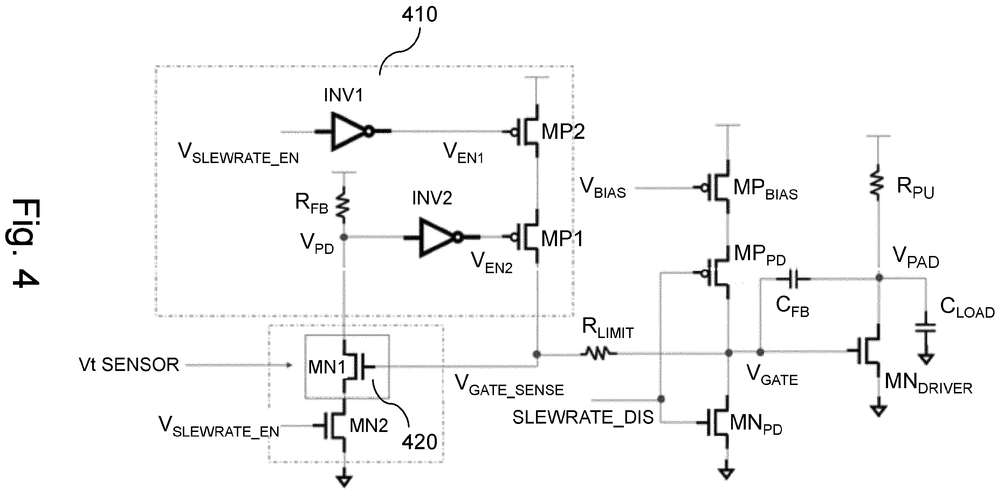

Figure 4 illustrates a proposed control circuit for an output driver with a slew rate control circuit. A turn-on facilitating module indicated by dashed box 410 and a sensing module indicated by solid box 420 together form the control circuit.

In Figure 4, the output driver is depicted as an open drain driver MN_{Driver}. The slew rate control circuit generates an output with constant slew rate over wide range of capacitive loads and supply voltages.

Without the fast turn on control circuit according to the present disclosure, the turning on the driver MN_{Driver} is always limited by the bias current through MP_{Bias}.

It will be described in the following how the slew rate control circuit is turned on quickly with the fast turn on control circuit of the present disclosure.

The turn-on facilitating module 410 comprises a turn-on path configured to be connected to an input terminal of the output driver and to connect a supply voltage to the input terminal of the output driver in response to the control voltage.

As shown in Figure 4, in an example, the turn-on path comprises a first switch, which may be a transistor MP2, and a second switch, which may be a transistor MP1, connected in series.

An enable terminal of the first switch is coupled to a control voltage V_{slewrate_en}, an enable terminal of the second switch is coupled to the supply voltage and an output terminal of the sensing module. An output terminal of the second switch is configured to be connected to the input terminal of the output driver.

Moreover, a gate of the transistor MP2 is coupled to the control voltage via a first inverter INV1, a gate of the transistor MP1 is coupled to the supply voltage via a second inverter INV2 and a feedback resistor R_{fb} connected in series.

The sensing module 420 comprises a sensing switch such as a transistor MN1. An input terminal, that is, a gate of the transistor MN1 is configured to be connected to the input terminal of the output driver. An output terminal of the sensing switch, that is, a drain of the transistor MN1 is coupled to the supply voltage and the enable terminal of the second switch of the turn-on path of the turn-on facilitating module 410.

A source of the transistor MN1 is connected to the control voltage via a second NMOS transistor MN2. A source of the second NMOS transistor MN2 is coupled to GND and a gate of the second NMOS transistor MN2 is coupled to the control voltage.

The control circuit comprising the Vt sensor MN1 and the turn-on facilitating module, which is a feedback control circuit, quickly charges V_{Gate} of the output driver to a threshold voltage. It ensures the turning on of MN_{Driver} in short amount of time. The time taken to charge V_{Gate} to a threshold voltage is not dependent on the bias current used during slew rate period.

The control circuit is turned off just before slew rate operation starts. The control circuit does not modify the slew rate defined by the slew rate control circuit. Instead, it always helps to reduce propagation delay by quickly turning on the output Driver.

### Modes of operation

The slew rate control with the fast turn on control circuit of the present disclosure operates in four states.
1. Driver OFF state - the state where the output driver, in Figure 2 the open drain driver, is turned off. At this state the control circuit is turned off.
2. Driver fast turn on state - the state where the open drain driver's gate voltage changes from 0V to Vt of the NMOS driver (MN_{Driver}). The present disclosure works in this region. The driver is turned off and fast turn on control circuit is activated.
3. Slew rate state - the state where the output driver is in slew rate operation and the fast turn on control circuit is deactivated.
4. Driver fully on state - the state where the output driver is fully on and the fast turn on control circuit is deactivated.

Detailed operation during each state is described in the following.

### Driver OFF state

During this state, input voltage of the output driver Disable net is High (VCC) and control input V_{slewrate_en} of the control cicuit is 0. This disables the output driver MN_{Driver}. V_{pad} reaches high (VCC) because of pull up resistance, Rₚᵤ.

V_{Gate} is pulled down to 0V as MN_{pd} is turned on.

V_{slewrate_en} = 0, Vₑₙ₁ = High, Vₑₙ₂ =0, V_{pd} = High, V_{Gate_sense} = 0.

MP2 is OFF and MP1 is ON which disable pull up current from MP1 and MP2.

MN1 is OFF and MN2 is OFF. This disables current path from VCC to ground through R_{fb}, MN1 and MN2.

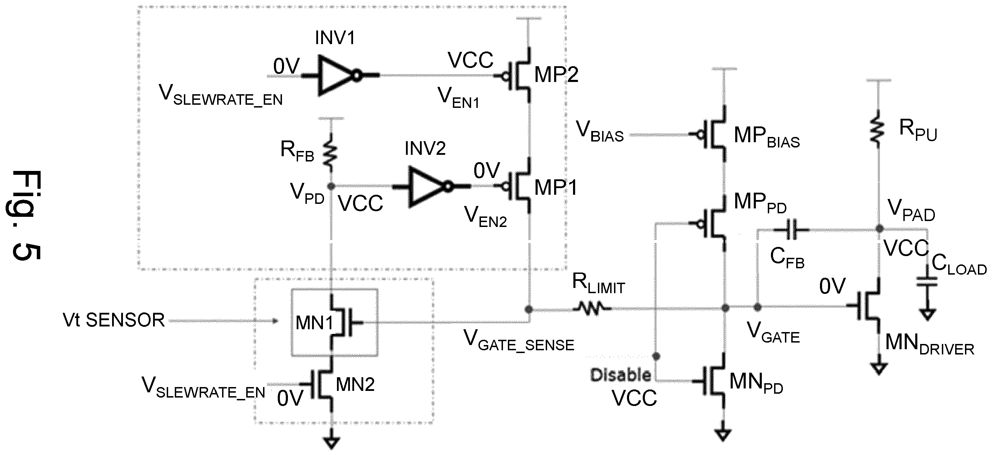

Figure 5 shows different node voltages of the circuit during this state.

### Driver fast turn on state

During this state, the input voltage of the output driver Disable = 0 and the control input V_{slewrate_en} of the control circuit is VCC which enables output the driver through two paths: the supplementary fast turn on path indicated by an arrow 69 and provided by the control circuit and the normal bias current path provided by the slew rate control circuit.

For the fast turn on path: Vₑₙ₁=0V and Vₑₙ₂=0V which enables MP1 and MP2. MN1 is off as V_{Gate_sense} < Vₜ. MN2 is turned on.

For the bias current path: Disable=0V which enables MP_{pd.}

MP1 and MP2 both are turned on, which allows V_{Gate_sense} to be quickly charged to a threshold voltage Vₜ of MN_{Driver}. The fast turn on path 69 is only operational during this period. Here the fast turn on path 69 is a strong pull up than the bias current path.

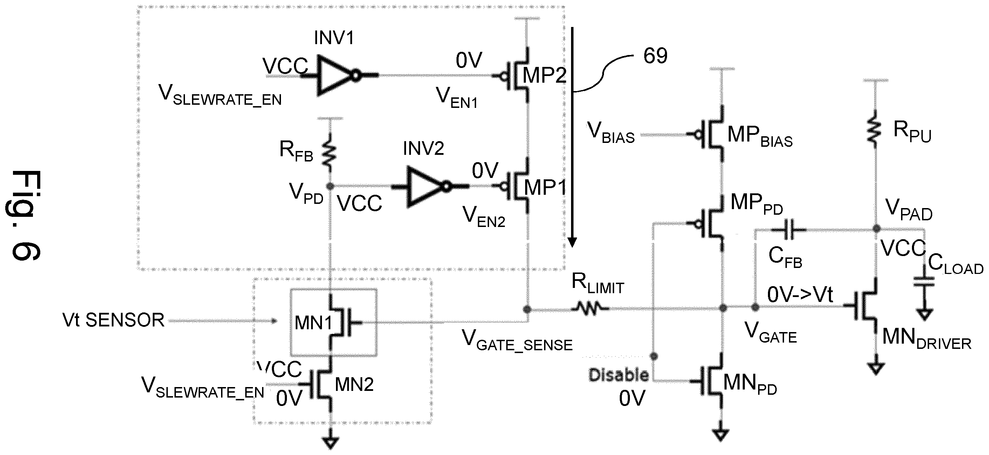

As soon as the gate voltage of the output driver V_{Gate_sense} reaches Vₜ, MN1 turns on and pulls down V_{pd} to 0V. This disables the fast turn on path by turning off MP1as shown in Figure 6.

Figure 6 shows different node voltages of the circuit during this state. V_{Gate} rises from 0V to Vₜ quickly as MP1 and MP2 charge V_{Gate} fast.

### Slew rate state

During this state, the control input V_{slewrate_en} is high, the input voltage of the output driver Disable is 0V. The output driver's gate voltage reaches Vₜ and starts operates in slew rate region. The output driver is only controlled with bias current from MP_{Bias}.

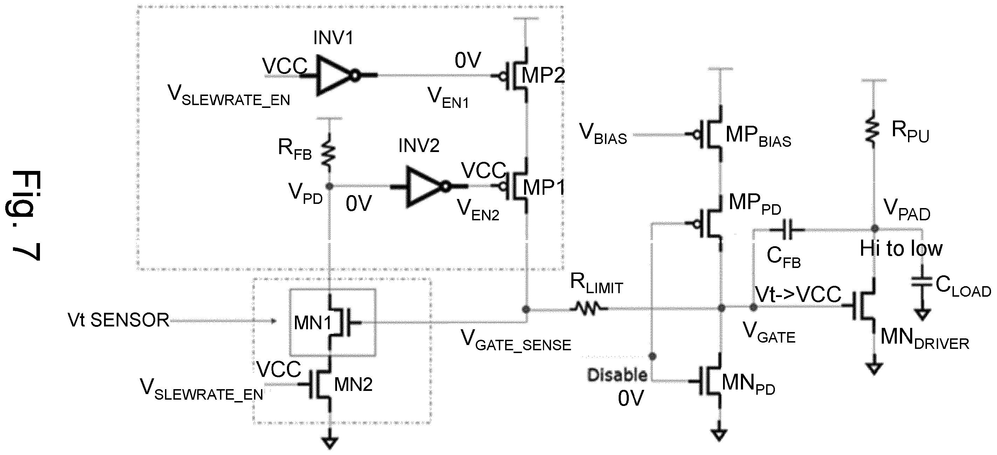

Figure 7 shows different node voltages of the circuit during this state.

### Driver fully ON state

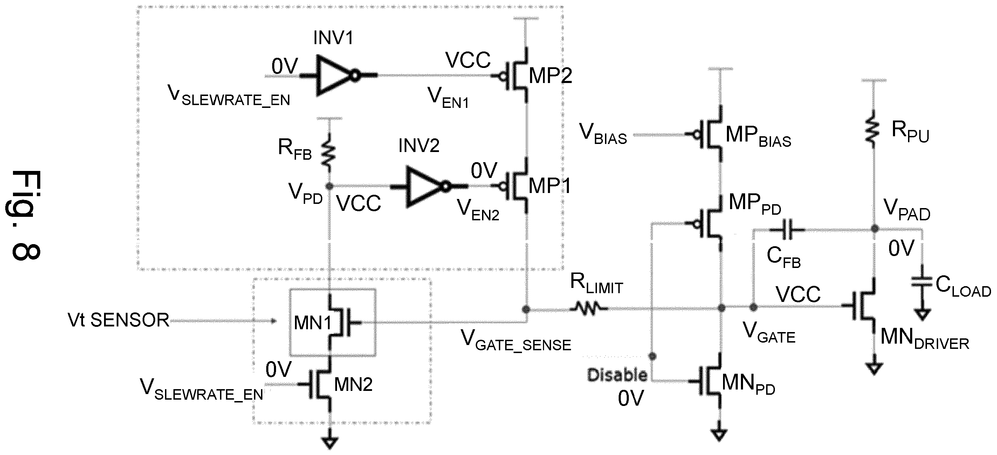

During this state, the control voltage V_{slewrate_en}=0, the input voltage of the output driver Disable =0V. MP2 is OFF and MP1 is ON and Vₑₙ₂ = low and Vₑₙ₁ = high. The output driver's gate voltage reaches high and drives driver output to low. Figure 8 shows different node voltages of the circuit during the state.

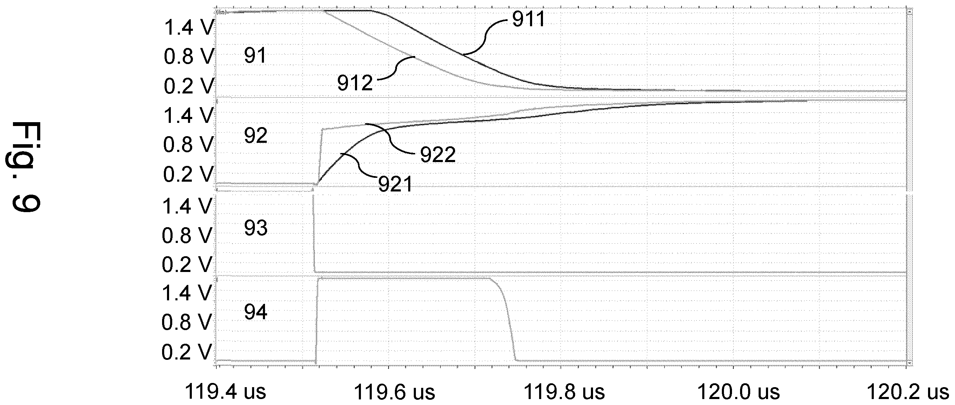

Figure 9 schematically illustrates comparison between slew rate circuit without and with the proposed control circuit. As a result of fast turning on the driver circuit, charging of the driver gate voltage doesn't depend on the bias current.

In Figure 9, the four graphs from top to bottom respectively representation of slew rate driver output 91, gate voltage 92 of the output driver, input signal 93 of the output driver and control voltage of the control circuit 94 of the present disclosure over time.

For the slew rate driver output 91, curve 911 indicates the slew rate driver output without the proposed control circuit, and curve 912 indicates the slew rate driver output with the proposed control circuit.

For the gate voltage 82 of the output driver, curve 921 indicate the gate voltage without the proposed control circuit, and curve 922 indicates the gate voltage with the proposed control circuit.

It is clearly seen with the proposed control circuit supplying the supplementary voltage, the gate voltage of the output driver is changed to the threshold value within a short period.

In case of fast corner process, the above described fast turn on control circuit might charge the gate voltage of the output driver too quickly. This can lead to modification of the slew rate control due to current injection on VGate. To avoid this a limiting resistor Rₗᵢₘᵢₜ as depicted in Figure 3 is used which limits current injection on V_{Gate} in case of fast corner.

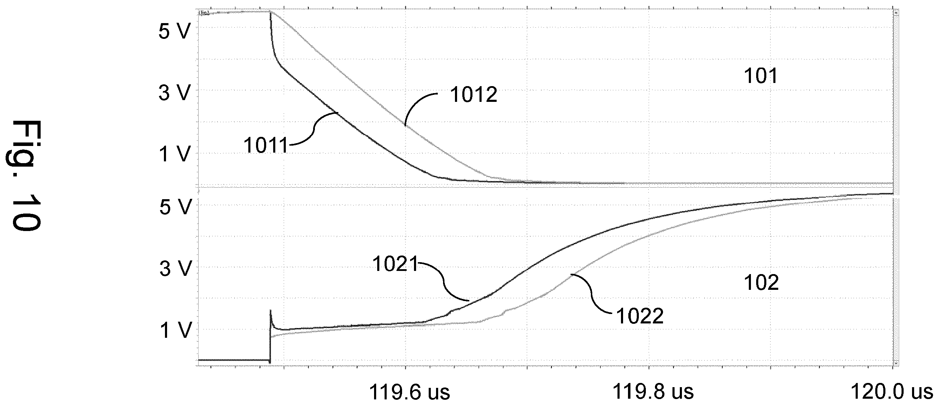

Figure 10 schematically illustrates comparison between slew rate circuit without and with the limiting resistor. In the current disclosure, the limiting resistor Rₗᵢₘᵢₜ limits the current through MP1 and MP2.

Figure 10 shows Slew rate driver output with Rₗᵢₘᵢₜ=0Ω and 400Ω. This case is more relevant at fast process and low capacitance load conditions. Graph 101 is a representation of the slew rate driver output, and graph 102 is a representation the gate voltage of the output driver.

When there is no Rₗᵢₘᵢₜ (Rₗᵢₘᵢₜ = 0Ω), the driver's gate voltage 1021 has a sharp spike and output 1011 quickly discharges before fast turn on circuit is disabled. This creates a non-uniform slew rate on the output as shown by the curve 811.

Using Rₗᵢₘᵢₜ between 200Ω to 600Ω, as illustrated in Figure 10 for Rₗᵢₘᵢₜ = 400Ω, the driver's gate voltage 1022 has no spike and the output 1012 never quickly discharges before fast turn on circuit is disabled. The output 1012 has constant slew rate throughout the slewing period.

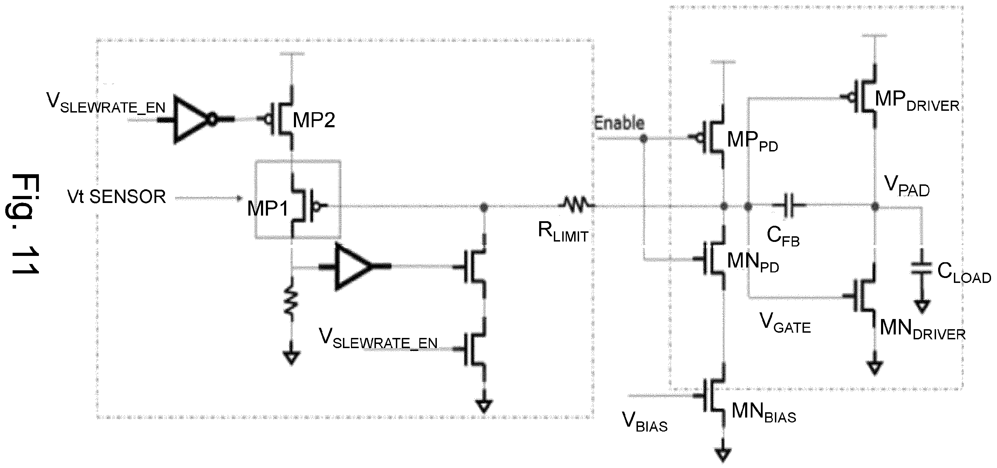

The control circuit as described above may also be used in connection with a push pull driver. Figure 11 schematically using the fast turn on control circuit for a PMOS driver. It may also enable the PMOS driver to have low propagation delay with well controlled slew rate. In Figure 11 the fast turn on control circuit is for P_{Driver} which is a part of a push pull driver.

## Claims

1. A control circuit (30) for an output driver (31) with a slew rate control circuit (32), comprising:
- a turn-on facilitating module (410) having a control input and configured to be connected to the output driver and to supply a supplementary voltage to the output driver in response to a control voltage at the control input; and
- a sensing module (420) configured to be connected to the turn-on facilitating module (410) and the output driver (31) and to switch off the turn-on facilitating module (410) in response to an input voltage of the output driver (31) sensed by the sensing module (420);
wherein the turn-on facilitating module (410) comprises a turn-on path configured to be connected to an input terminal of the output driver (31) and to connect a supply voltage to the input terminal of the output driver (31) in response to the control voltage, and wherein the turn-on path comprises a first switch (MP2) and a second switch (MP1) connected in series, with an enable terminal of the first switch (MP2) coupled to the control voltage, and an enable terminal of the second switch (MP1) coupled to the supply voltage and an output terminal of the sensing module (420), with an output terminal of the second switch (MP1) configured to be connected to the input terminal of the output driver (31),
wherein the first switch comprises a first PMOS transistor and the second switch comprises a second PMOS transistor, a source of the first PMOS transistor is coupled to the supply voltage and a drain of the first PMOS transistor is coupled to a source of the second PMOS transistor,
**characterised in that** a drain of the second switch is configured to be connected to the input terminal of the output driver via a limiting resistor (Rₗᵢₘᵢₜ) comprised in the control circuit and having a first terminal connectable to the input terminal of the output driver (31) and a second terminal coupled to the turn-on facilitating module (410) and the sensing module (420).

2. The control circuit according to claim 1, wherein a gate of the first PMOS transistor (MP2) is coupled to the control voltage via a first inverter (INV1), a gate of the second PMOS transistor (MP1) is coupled to the supply voltage via a second inverter (INV2) and a feedback resistor (R_{FB}) connected in series.

3. The control circuit according to claim 1 or 2, wherein the sensing module (420) comprises a third switch configured to have its input terminal connected to the input terminal of the output driver (31) via the limiting resistor and an output terminal coupled to the supply voltage and the enable terminal of the second switch.

4. The control circuit according to claim 3, wherein the third switch comprises a first NMOS transistor (MN1), a source of the first NMOS transistor (MN1) is connected to the control voltage via a second NMOS transistor (MN2).

5. The control circuit according to claim 4, wherein a source of the second NMOS transistor (MN2) is coupled to GND and a gate of the second NMOS transistor (MN2) is coupled to the control voltage.

6. The control circuit according to claim 3 or 4, wherein the output terminal of the first NMOS transistor (MN1) is coupled to a node between the second inverter (INV2) and the feedback resistor (R_{FB}).

7. The control circuit according to claim 3, wherein the second terminal of the limiting resistor (Rₗᵢₘᵢₜ) is coupled to the source of the second switch (MP1) and the input terminal of the third switch.

8. The control circuit according to claim 7, wherein the limiting resistor (Rₗᵢₘᵢₜ) has a resistance in a range of 200 Ohm to 600 Ohm.

9. An output driver comprising a slew rate control circuit and the control circuit for the slew rate control circuit according to any of the previous claims 1 to 8.

10. The output driver according to claim 9, comprising an open drain output driver.

11. The output driver according to claim 9, comprising a push pull driver.

## Patentansprüche

1. Steuerschaltung (30) für einen Ausgangstreiber (31) mit einer Anstiegsgeschwindigkeitssteuerschaltung (32), umfassend:
- ein Einschalterleichterungsmodul (410), das einen Steuereingang aufweist und konfiguriert ist, um mit dem Ausgangstreiber verbunden zu werden und dem Ausgangstreiber als Reaktion auf eine Steuerspannung am Steuereingang eine zusätzliche Spannung zuzuführen; und
- ein Erfassungsmodul (420), das konfiguriert ist, um mit dem Einschalterleichterungsmodul (410) und dem Ausgangstreiber (31) verbunden zu werden und um das Einschalterleichterungsmodul (410) als Reaktion auf eine Eingangsspannung des Ausgangstreibers (31), die von dem Erfassungsmodul (420) erfasst wird, auszuschalten;
- wobei das Einschalterleichterungsmodul (410) einen Einschaltpfad umfasst, der konfiguriert ist, um mit einem Eingangsanschluss des Ausgangstreibers (31) verbunden zu werden und um eine Versorgungsspannung mit dem Eingangsanschluss des Ausgangstreibers (31) als Reaktion auf die Steuerspannung zu verbinden, und wobei der Einschaltpfad einen ersten Schalter (MP2) und einen zweiten Schalter (MP1) umfasst, die in Reihe geschaltet sind, wobei ein Freigabeanschluss des ersten Schalters (MP2) mit der Steuerspannung gekoppelt ist, und ein Freigabeanschluss des zweiten Schalters (MP1) mit der Versorgungsspannung und einem Ausgangsanschluss des Erfassungsmoduls (420) gekoppelt ist, wobei ein Ausgangsanschluss des zweiten Schalters (MP1) konfiguriert ist, um mit dem Eingangsanschluss des Ausgangstreibers (31) verbunden zu werden,
- wobei der erste Schalter einen ersten PMOS-Transistor umfasst und der zweite Schalter einen zweiten PMOS-Transistor umfasst, eine Source des ersten PMOS-Transistors mit der Versorgungsspannung gekoppelt ist und ein Drain des ersten PMOS-Transistors mit einer Source des zweiten PMOS-Transistors gekoppelt ist,
- **dadurch gekennzeichnet, dass** ein Drain des zweiten Schalters konfiguriert ist, um mit dem Eingangsanschluss des Ausgangstreibers über einen Begrenzungswiderstand (Rₗᵢₘᵢₜ) verbunden zu werden, der in der Steuerschaltung umfasst ist und einen ersten Anschluss, der mit dem Eingangsanschluss des Ausgangstreibers (31) verbunden werden kann, und einen zweiten Anschluss aufweist, der mit dem Einschalterleichterungsmodul (410) und dem Erfassungsmodul (420) gekoppelt ist.

2. Steuerschaltung nach Anspruch 1, wobei ein Gate des ersten PMOS-Transistors (MP2) über einen ersten Inverter (INV1) mit der Steuerspannung gekoppelt ist, ein Gate des zweiten PMOS-Transistors (MP1) über einen zweiten Inverter (INV2) und einen in Reihe geschalteten Rückkopplungswiderstand (R_{FB}) mit der Versorgungsspannung gekoppelt ist.

3. Steuerschaltung nach Anspruch 1 oder 2, wobei das Erfassungsmodul (420) einen dritten Schalter umfasst, der so konfiguriert ist, dass sein Eingangsanschluss über den Begrenzungswiderstand mit dem Eingangsanschluss des Ausgangstreibers (31) verbunden ist und ein Ausgangsanschluss mit der Versorgungsspannung und dem Freigabeanschluss des zweiten Schalters gekoppelt ist.

4. Steuerschaltung nach Anspruch 3, wobei der dritte Schalter einen ersten NMOS-Transistor (MN1) umfasst, wobei eine Source des ersten NMOS-Transistors (MN1) über einen zweiten NMOS-Transistor (MN2) mit der Steuerspannung verbunden ist.

5. Steuerschaltung nach Anspruch 4, wobei eine Source des zweiten NMOS-Transistors (MN2) mit GND gekoppelt ist und ein Gate des zweiten NMOS-Transistors (MN2) mit der Steuerspannung gekoppelt ist.

6. Steuerschaltung nach Anspruch 3 oder 4, wobei der Ausgangsanschluss des ersten NMOS-Transistors (MN1) mit einem Knoten zwischen dem zweiten Inverter (INV2) und dem Rückkopplungswiderstand (R_{FB}) gekoppelt ist.

7. Steuerschaltung nach Anspruch 3, wobei der zweite Anschluss des Begrenzungswiderstands (Rₗᵢₘᵢₜ) mit der Source des zweiten Schalters (MP1) und dem Eingangsanschluss des dritten Schalters gekoppelt ist.

8. Steuerschaltung nach Anspruch 7, wobei der Begrenzungswiderstand (Rₗᵢₘᵢₜ) einen Widerstand in einem Bereich von 200 Ohm bis 600 Ohm aufweist.

9. Ausgangstreiber, umfassend eine Anstiegsgeschwindigkeitssteuerschaltung und die Steuerschaltung für die Anstiegsgeschwindigkeitssteuerschaltung nach einem der vorstehenden Ansprüche 1 bis 8.

10. Ausgangstreiber nach Anspruch 9, der einen Open-Drain-Ausgangstreiber umfasst.

11. Ausgangstreiber nach Anspruch 9, der einen Push-Pull-Treiber umfasst.

## Revendications

1. Circuit de commande (30) destiné à un pilote de sortie (31) pourvu d'un circuit de commande de vitesse de balayage (32), comprenant :
- un module de facilitation de mise sous tension (410) ayant une entrée de commande et conçu pour être connecté au pilote de sortie et pour fournir une tension supplémentaire au pilote de sortie en réponse à une tension de commande au niveau de l'entrée de commande ; et
- un module de détection (420) conçu pour être connecté au module de facilitation de mise sous tension (410) et au pilote de sortie (31) et pour désactiver le module de facilitation de mise sous tension (410) en réponse à une tension d'entrée du pilote de sortie (31) détecté par le module de détection (420) ;
dans lequel le module de facilitation de mise sous tension (410) comprend un chemin de mise sous tension conçu pour être connecté à une borne d'entrée du pilote de sortie (31) et pour connecter une tension d'alimentation à la borne d'entrée du pilote de sortie (31) en réponse à la tension de commande, et dans lequel le chemin de mise sous tension comprend un premier commutateur (MP2) et un deuxième commutateur (MP1) connectés en série, avec une borne d'activation du premier commutateur (MP2) couplée à la tension de commande, et une borne d'activation du deuxième commutateur (MP1) couplée à la tension d'alimentation et une borne de sortie du module de détection (420), avec une borne de sortie du deuxième commutateur (MP1) conçue pour être connectée à la borne d'entrée du pilote de sortie (31), dans lequel le premier commutateur comprend un premier transistor PMOS et le deuxième commutateur comprend un deuxième transistor PMOS, une source du premier transistor PMOS est couplée à la tension d'alimentation et un drain du premier transistor PMOS est couplé à une source du deuxième transistor PMOS,
**caractérisé en ce qu'**un drain du deuxième commutateur est conçu pour être connecté à la borne d'entrée du pilote de sortie par l'intermédiaire d'une résistance de limitation (Rₗᵢₘᵢₜ) comprise dans le circuit de commande et ayant une première borne qui peut être connectée à la borne d'entrée du pilote de sortie (31) et une deuxième borne couplée au module de facilitation de mise sous tension (410) et au module de détection (420).

2. Circuit de commande selon la revendication 1, dans lequel une grille du premier transistor PMOS (MP2) est couplée à la tension de commande par l'intermédiaire d'un premier inverseur (INV1), une grille du deuxième transistor PMOS (MP1) est couplée à la tension d'alimentation par l'intermédiaire d'un deuxième inverseur (INV2) et d'une résistance de rétroaction (R_{FB}) connectés en série.

3. Circuit de commande selon la revendication 1 ou 2, dans lequel le module de détection (420) comprend un troisième commutateur conçu pour que sa borne d'entrée soit connectée à la borne d'entrée du pilote de sortie (31) par l'intermédiaire de la résistance de limitation et qu'une borne de sortie soit couplée à la tension d'alimentation et à la borne d'activation du deuxième commutateur.

4. Circuit de commande selon la revendication 3, dans lequel le troisième commutateur comprend un premier transistor NMOS (MN1), une source du premier transistor NMOS (MN1) est connectée à la tension de commande par l'intermédiaire d'un deuxième transistor NMOS (MN2).

5. Circuit de commande selon la revendication 4, dans lequel une source du deuxième transistor NMOS (MN2) est couplée à la masse et une grille du deuxième transistor NMOS (MN2) est couplée à la tension de commande.

6. Circuit de commande selon la revendication 3 ou 4, dans lequel la borne de sortie du premier transistor NMOS (MN1) est couplée à un nœud entre le deuxième inverseur (INV2) et la résistance de rétroaction (R_{FB}).

7. Circuit de commande selon la revendication 3, dans lequel la deuxième borne de la résistance de limitation (Rₗᵢₘᵢₜ) est couplée à la source du deuxième commutateur (MP1) et à la borne d'entrée du troisième commutateur.

8. Circuit de commande selon la revendication 7, dans lequel la résistance de la résistance de limitation (Rₗᵢₘᵢₜ) se situe dans une plage de 200 Ohm à 600 Ohm.

9. Pilote de sortie comprenant un circuit de commande de vitesse de balayage et le circuit de commande destiné au circuit de commande de vitesse de balayage selon l'une quelconque des revendications 1 à 8.

10. Pilote de sortie selon la revendication 9, comprenant un pilote de sortie à drain ouvert.

11. Pilote de sortie selon la revendication 9, comprenant un pilote push-pull.
